(19) Europäisches Patentamt
European Patent Office
Office européen des brevets

(11) **EP 4 715 083 A2**

(12) **EUROPEAN PATENT APPLICATION**

(43) Date of publication:
**25.03.2026 Bulletin 2026/13**

(21) Application number: **25201087.1**

(22) Date of filing: **09.09.2025**

(51) International Patent Classification (IPC):
**C23C 14/04** (2006.01)  **C23C 14/08** (2006.01)
**C23C 14/10** (2006.01)  **C23C 14/34** (2006.01)

(52) Cooperative Patent Classification (CPC):
**C23C 14/044; C23C 14/08; C23C 14/10;
C23C 14/34**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.09.2024 GB 202414013**

(71) Applicant: **Envisics Ltd
Milton Keynes MK1 1PT (GB)**

(72) Inventor: **XIA, Yiren
Milton Keynes, MK1 1PT (GB)**

(74) Representative: **Greenaway, Martin William
Apollo House
6 Bramley Road
Milton Keynes MK1 1PT (GB)**

(54) **VARIABLE GRADIENT THICKNESS COATING**

(57)    A coating device comprising a sample carrier, a source, shadow mask and coating driver. The source comprises a plurality of targets such as a first target and second target. The source is arranged to coat at least one sample housed in the sample carrier. The shadow mask is disposed in a line-of-sight between the sample carrier and source. The shadow mask is arranged such that the first target provides a first coating contribution. The shadow mask is further arranged such that the second target provides a second coating contribution. The second coating contribution is different to the first coating contribution. At least one of the first and second coating contributions is non-uniform in a first dimension of the sample. The coating driver is arranged to independently control the first coating contribution and second coating contribution such that a thickness gradient of the coating in the first direction is variable.

FIGURE 10

## Description

FIELD

The present disclosure relates to a device for applying a coating and a method of coating. More specifically, the present disclosure relates to a coating device and a method of coating a plurality of sample. Yet more specifically, the present disclosure relates to a coating device arranged to provide a variable gradient thickness coating or film and a method of coating a sample with a variable gradient thickness coating or film. The present disclosure also relates to a waveguide and a method of coating a waveguide with a material or film having a gradient or graded thickness.

BACKGROUND AND INTRODUCTION

Light scattered from an object contains both amplitude and phase information. This amplitude and phase information can be captured on, for example, a photosensitive plate by well-known interference techniques to form a holographic recording, or "hologram", comprising interference fringes. The hologram may be reconstructed by illumination with suitable light to form a two-dimensional or three-dimensional holographic reconstruction, or replay image, representative of the original object.

Computer-generated holography may numerically simulate the interference process. A computer-generated hologram may be calculated by a technique based on a mathematical transformation such as a Fresnel or Fourier transform. These types of holograms may be referred to as Fresnel/Fourier transform holograms or simply Fresnel/Fourier holograms. A Fourier hologram may be considered a Fourier domain/plane representation of the object or a frequency domain/plane representation of the object. A computer-generated hologram may also be calculated by coherent ray tracing or a point cloud technique, for example.

A computer-generated hologram may be encoded on a spatial light modulator arranged to modulate the amplitude and/or phase of incident light. Light modulation may be achieved using electrically-addressable liquid crystals, optically-addressable liquid crystals or micro-mirrors, for example.

A spatial light modulator typically comprises a plurality of individually-addressable pixels which may also be referred to as cells or elements. The light modulation scheme may be binary, multilevel or continuous. Alternatively, the device may be continuous (i.e. is not comprised of pixels) and light modulation may therefore be continuous across the device. The spatial light modulator may be reflective meaning that modulated light is output in reflection. The spatial light modulator may equally be transmissive meaning that modulated light is output in transmission.

A holographic projector may be provided using the system described herein. Such projectors have found application in head-up displays, "HUD".

SUMMARY

Aspects of the present disclosure are defined in the appended independent claims.

Summary of holographic projection and wavefront replication

Broadly, the present disclosure relates to image projection. It relates to a method of image projection and an image projector which comprises a display device. The present disclosure also relates to a projection system comprising the image projector and a viewing system, in which the image projector projects or relays light from the display device to the viewing system. The present disclosure is equally applicable to a monocular and binocular viewing system. The viewing system may comprise a viewer's eye or eyes. The viewing system comprises an optical element having optical power (e.g., lens/es of the human eye) and a viewing plane (e.g., retina of the human eye/s). The projector may be referred to as a 'light engine'. The display device and the image formed (or perceived) using the display device are spatially separated from one another. The image is formed, or perceived by a viewer, on a display plane. In some embodiments, the image is a virtual image and the display plane may be referred to as a virtual image plane. In other embodiments, the image is a real image formed by holographic reconstruction and the image is projected or relayed to the viewing plane. The image is formed by illuminating a diffractive pattern (e.g., hologram) displayed on the display device.

The display device comprises pixels. The pixels of the display device diffract light. In accordance with well-understood optics, the magnitude of the maximum diffraction angle is determined by the size of the pixels (and other factors such as the wavelength of light).

In embodiments, the display device is a spatial light modulator such as liquid crystal on silicon ("LCOS") spatial light modulator (SLM). Light propagates over a range of diffraction angles (for example, from zero to the maximum diffractive angle) from the LCOS, towards a viewing entity/system such as a camera or an eye. In some embodiments, magnification techniques may be used to increase the range of available diffraction angles beyond the conventional maximum diffraction angle of an LCOS.

In some examples, an image (formed from the displayed hologram) is propagated to the eyes. For example, spatially modulated light of an intermediate holographic reconstruction / image formed either in free space or on a screen or other light receiving surface between the display device and the viewer, may be propagated to the viewer.

In some other examples, the (light of a) hologram itself is propagated to the eyes. For example, spatially modulated light of the hologram (that has not yet been fully transformed to a holographic reconstruction, i.e. image) - that may be informally said to be "encoded" with/by the hologram - is propagated directly to the viewer's eyes. A real or virtual image may be perceived by the viewer. In these embodiments, there is no intermediate holographic reconstruction / image formed between the display device and the viewer. It is sometimes said that, in these embodiments, the lens of the eye performs a hologram-to-image conversion or transform. The projection system, or light engine, may be configured so that the viewer effectively looks directly at the display device.

In accordance with the principles of well-understood optics, the range of angles of light propagating from a display device that can be viewed, by an eye or other viewing entity/system, varies with the distance between the display device and the viewing entity. At a 1 metre viewing distance, for example, only a small range of angles from an LCOS can propagate through an eye's pupil to form an image at the retina for a given eye position. The range of angles of light rays that are propagated from the display device, which can successfully propagate through an eye's pupil to form an image at the retina for a given eye position, determines the portion of the image that is 'visible' to the viewer. In other words, not all parts of the image are visible from any one point on the viewing plane (e.g., any one eye position within a viewing window such as eye-motion box.)

In some embodiments, the image perceived by a viewer is a virtual image that appears upstream of the display device - that is, the viewer perceives the image as being further away from them than the display device. Conceptually, it may therefore be considered that the viewer is looking at a virtual image through an 'display device-sized window', which may be very small, for example 1cm in diameter, at a relatively large distance, e.g., 1 metre. And the user will be viewing the display device-sized window via the pupil(s) of their eye(s), which can also be very small. Accordingly, the field of view becomes small and the specific angular range that can be seen depends heavily on the eye position, at any given time.

A pupil expander addresses the problem of how to increase the range of angles of light rays that are propagated from the display device that can successfully propagate through an eye's pupil to form an image. The display device is generally (in relative terms) small and the projection distance is (in relative terms) large. In some embodiments, the projection distance is at least one - such as, at least two - orders of magnitude greater than the diameter, or width, of the entrance pupil and/or aperture of the display device (i.e., size of the array of pixels).

Use of a pupil expander increases the viewing area (i.e., user's eye-box) laterally, thus enabling some movement of the eye/s to occur, whilst still enabling the user to see the image. As the skilled person will appreciate, in an imaging system, the viewing area (user's eye-box) is the area in which a viewer's eyes can perceive the image. The present disclosure particularly relates to non-infinite virtual image distances - that is, near-field virtual images - but is equally applicable to virtual images formed at infinity or even real images formed downstream of the display device / hologram.

The display device may have an active or display area having a first dimension that may be less than 10 cms such as less than 5 cms or less than 2 cms. The propagation distance between the display device and viewing system may be greater than 1 m such as greater than 1.5 m or greater than 2 m. The optical propagation distance within the waveguide may be up to 2 m such as up to 1.5 m or up to 1 m. The method may be capable of receiving an image and determining a corresponding hologram of sufficient quality in less than 20 ms such as less than 15 ms or less than 10 ms.

Broadly, a system is disclosed herein that provides pupil expansion for an input light field or wavefront. The input light field may be a diffracted or holographic light field comprising diverging ray bundles and the display system may be described as hologram-to-eye. In this case, the input light field is spatially modulated in accordance with a hologram of an image. Alternatively, the input light field may be an image and the display system may comprise a screen, such as a diffuser, arranged to form the image thereon. In this case, the input light field is spatially modulated in accordance with an image. In both cases, the input light field is replicated to form a 1D or 2D array of replicas. For the avoidance of doubt, the present disclosure is equally applicable to both techniques. In particular, the coating or thin film or method of forming the same in accordance with the present disclosure is equally applicable to waveguiding and replicating a hologram or an image.

In the present disclosure, the term "replica" is merely used to reflect that spatially modulated light is divided such that a complex light field or wavefront is directed along a plurality of different optical paths. The word "replica" is used to refer to each occurrence or instance of the complex light field or wavefront after a replication event - such as a partial reflection-transmission by a pupil expander. Each replica travels along a different optical path. Some embodiments of the present disclosure relate to propagation of light that is encoded with a hologram, not an image - i.e., light that is spatially modulated with a hologram of an image, not the image itself. The person skilled in the art of holography will appreciate that the complex light field associated with propagation of light encoded with a hologram will change with propagation distance. Use herein of the term "replica" is independent of propagation distance and so the two branches or paths of light associated with a replication event are still referred to as "replicas" of each other even if the branches are a different length, such that the complex light field has evolved differently along each path. That is, two complex light fields are still considered "replicas" in accordance with this disclosure even if they are associated with different propagation distances - providing they have arisen from the same replication event or series of replication events.

As above, an optical waveguide for use as a pupil expander may lightguide or waveguide a light field or wavefront between a pair of parallel surfaces. This may be achieved by internal reflection between the parallel surfaces. A first surface of the pair of surfaces may be partially transmissive-reflective. A second surface of the pair of surfaces may be reflective. The light field will therefore be divided at each internal reflection at the first surface such that a plurality of replicas of the light field is transmitted through a region of the first surface that forms an output port of the waveguide. Thus, a viewing window (and eye-box) is enlarged by the waveguide.

The intensity and spectrum of each successive replica emitted by the waveguide is required to be substantially constant from replica to replica. For example, an integral of the intensity of the light of each replica may be substantially constant, a mean average of the intensity of the light of each replica may be substantially constant and / or a distribution of the intensity of the light of each replica may be substantially constant. Replicas having substantially constant intensity and spectra are referred to herein as being spatially homogenous and a waveguide emitting such replicas is referred to herein as providing spatially homogenous emission. Spatially homogenous replicas advantageously reduce or minimize the variability in the brightness of the image perceived (or different areas thereof) by a viewer moving around the (expanded) viewing window. Furthermore, the overall quality of the hologram received by the viewer (and / or the resulting image perceived by the viewer) may be improved, particularly if the hologram comprises a plurality of different wavelengths of light.

The intensity of the light being waveguided between the first and second surfaces of the waveguide will decrease after each division of the light field at the first surface. A sub-optimal waveguide may typically comprise a first surface with constant reflectivity. This results in the intensity of each successive replica decreasing. In other words, such conventional waveguides do not provide spatially homogenous emission.

A graded coating or gradient thickness coating can be applied to the waveguide to provide a first surface having a varying reflectivity and therefore transmissivity. In particular, the coating may be arranged so that the transmissivity of the first surface increases in the direction of waveguiding. The graded coating may be arranged such that the increased transmissivity of the first surface in the direction of waveguiding accounts (e.g. at least partially compensates) for the decrease in the intensity of light being light guided. However, current graded coatings often result in high absorption losses of the waveguided light. Furthermore, these coatings typically allow for very limited control of spectral performance, particularly disadvantageous when the light to be waveguided comprises multiple wavelengths. While some improved graded coatings are available, these are expensive, time consuming and complex to manufacture and generally cannot be manufactured reliably. For example, such coatings may comprise a plurality (often 20 or more) layers of dielectric material, each layer having a unique percentage change of the thickness from a first end of the layer to a second end. Such a complex layered structure may be necessary to provide substantially spatially homogenous emission for the full visible spectrum but is slow to manufacture and difficult to manufacture reliably (for example, a moving grader may be required to be present in the coating chamber).

Summary of waveguide coating

Broadly, the present disclosure addresses a technical problem of providing a spatially homogenous emission from a waveguide pupil expander such that the intensity and spectrum of each replica is substantially similar. The present disclosure proposes an improved waveguide pupil expander which provides substantially homogeneous emission at least at specific wavelengths such as a red, green and blue wavelength. A first surface of the waveguide comprises a plurality of alternating layers of a first and a second dielectric that differ in refractive index. In some examples, each layer has a unique percentage change of thickness. In some examples, each layer of dielectric has a percentage change of thickness.

The multilayer structure resulting from conventional design techniques is very complex and has low suitability for industrial scale-up. The complexity is partly caused by the need to achieve uniformity at three different wavelengths. This design process has been rethought and focused on restricting it in ways that simplify the manufacturing method that will be needed and relaxing it in other ways that do not impact the image-forming (e.g. holographic) process. In particular, focused has been placed on how to increase speed and reduce the number of hardware changes required during coating because these may require time inefficient processes related to opening the coating chamber such as re-evacuating the chamber.

According to examples, a waveguide is provided. The waveguide comprises a pair of parallel / complementary surfaces arranged to provide waveguiding therebetween. A first surface of the pair of parallel surfaces comprises a plurality of layers of a first dielectric and a plurality of layers of second dielectric arranged in an alternating configuration. Each layer of the first and second dielectric has a first end and a second end. The first end may be a (light) input end and the second end may be a (light) output end for the final replica or the end of an output port/window. A percentage change in the thickness of each layer from the first end to the second end of that layer has one of a plurality of discrete (e.g. allowable) values. The total number of layers of the first and second dielectric is greater than the total number of discrete values. A difference in refractive index between the first dielectric and second dielectric is greater than 0.4, optionally greater than 0.5.

References to "percentage change in the thickness" of a layer herein refer to the percentage change in thickness of that layer from the first end of that layer to the second end of that layer, unless specified otherwise. The percentage change in the thickness of a layer may be: $100 \times (t_f - t_i) / t_i$, wherein $t_i$ is the thickness of the respective layer at the first end and $t_f$ us the thickness of the respective layer at the second end.

Generally, each layer of the plurality of layers may be parallel to the other layers. The first end of each of layer may be aligned with the first end of the other layers and the second end of each layer may be aligned with the other layers. In other words, each layer may have a substantially similar length and /or width as the other layers but may differ in thickness or depth. The plurality of layers of the first and second dielectric may be referred to as a stack of layers or, simply, dielectric stack.

As used herein, the "alternating configuration" of the layers of the first and second dielectric means that each layer of the first dielectric is separated from the next closest layer(s) of first dielectric by a layer of the second dielectric, and vice versa.

In some examples, more than two, optionally four or more, optionally 6 or more, optionally 8 or more, optionally 10 or more layers of the plurality of layer may have the same percentage change of thickness from the respective first end to the respective second end (and so these layers may be associated with the same discrete value). In some examples, the layers that have the same percentage change of thickness as each other are layers of the same dielectric (i.e. all layers having a particular percentage change of thickness value are layers of the first dielectric or layers of the second dielectric).

Each of the layers of the first or second dielectric may increase or decrease in thickness in the direction of waveguiding. A first direction may be defined from the first end to the second end of each of the plurality of layers. The pair of parallel surfaces may be arranged to provide waveguiding in the first direction. In other words, light waveguided by the pair of surfaces may interact with the first end before interacting with the second end. Furthermore, each of the layers of the first or second dielectric may increase or decrease in thickness in the first direction.

The minimum thickness of each of the plurality of layers of the first and second dielectric, as well as the discrete values for the percentage change in thickness, may be selected to provide a waveguide with desired optical properties, in particular with a desired transmissive behaviour such that a spatially homogenous emission is generated. The parameters may depend on (among other things) the material properties (in particular, the refractive index) of the first and second dielectric, the angle of incidence of light entering the waveguide, the wavelength(s) of the incident light and the distance between the pair of parallel surfaces of the waveguide. As will appreciated by the skilled person, there will be a plurality (usually a relatively large number) of arrangements of the plurality of layers that provide a waveguide with desired optical properties. However, common to all of these arrangements are the advantages that the layered structure of the first surface provides desired optical properties and can be manufactured quickly, inexpensively and reliably.

One example of a fast, inexpensive and reliable method of manufacturing the layers of the first and second dielectric may comprise forming the layers by depositing the respective dielectric material on a waveguide substrate. A shadow mask may be used to control the flow of the dielectric material onto the substrate. Preferably, a shadow mask with a trapezoidal shape may be used. The percentage change in thickness of each layer may be determined by the shape of the mask and the overall thickness of each layer may be determined by the length of time that the dielectric material is allowed to flow. When the mask is trapezoidal, the percentage change in thickness of each layer may correspond to a percentage change in the short base to the long base of the trapezoid shape of the shadow mask. A different mask may be associated with each of the discrete values. For example, if there are first to fourth percentage change values then four different masks may be used to manufacture the layers of the coating. The waveguide substrate may advantageously simply be moved between different material sources having different masks.

Preferably, the rate of change of the thickness of each layer may be constant. In other words, each of the layers may have a linear profile. It may be simpler to manufacture dielectric layers having a linear profile. Furthermore, the skilled person will appreciate that it may be more straightforward to calculate / determine discrete allowable values for a stack of layers having a linear profile.

In some embodiments, the first surface may provide a plurality, n, of light emission zones for light waveguided between the first surface and second surface. The plurality of light emission zones may be distributed along a length of the first surface, in the direction of waveguiding. A replica of the input wavefront may be generated at each emission zone. The first end of each layer of the first and second dielectric layer may be at or adjacent to the first light emission zone. The second end of each layer of the first and second dielectric later may be at or adjacent to the nth light emission zone.

An angle of internal incidence at each emission zones may be in the range 0 to 70 degrees, preferably in the range of 10 to 50 degrees.

At other wavelengths (i.e. not the first, second and third visible wavelength), the transmissivity of the first surface may or may not increase in the direction of waveguiding. As previously described, the waveguide of the present disclosure may be particularly advantageous in the context of waveguiding light at discrete wavelengths, rather than waveguiding light having a continuous spectrum. The inventors have appreciated that the parameters such as thickness and the values for the percentage change of thickness of the plurality of layers of the first and second dielectrics may be selected to provide a desired changing transmissivity behaviour at the first, second and third wavelengths only and that there may be no need for the layers to provide that same transmissivity behaviour at other wavelengths. The inventors have found that by confining the problem of providing a changing transmissivity behaviour to only certain wavelengths, a coating comprising multiple layers having the same rate of change of thickness can provide the desired transmissivity behaviour which, as above, can be manufactured inexpensively, quickly and reliably while still providing acceptable transmissive properties.

The first wavelength, referred to above, may preferably be in the range 630-670 nm. The second wavelength may preferably be in the range 500-540 nm. The third wavelength may preferably be in the range 430-470 nm. In other words, the first wavelength may correspond to red visible light. The second wavelength may correspond to green visible light. The third wavelength may correspond to blue visible light.

Preferably, the transmissivity of the first surface at each emission point, $T(n)$, may satisfy the following equation: $T(n)=(T(n-1))/([1-T(n-1)]\times[1-L])$ wherein L is an optical loss factor of the waveguide material.

The first dielectric may be a first oxide, fluoride, sulfide or nitrate of a first transition metal or semiconductor. The second dielectric may be a second oxide, fluoride, sulfide or nitrate of a second transition metal or semiconductor. In some embodiments, the first dielectric comprises silicon, titanium, tantalum or hafnium. In some embodiments, the second dielectric comprises another of silicon, titanium, tantalum or hafnium.

Each layer may have a thickness in the range 2 to 300 nm. The thickness of each layer may not fall outside of this range at any point between the first end and second end. In some embodiments, each layer may have a thickness in the range 20 to 300 nm.

A minimum thickness of each layer may be between 2 and 300 nm, optionally between 20 and 300 nm. A maximum thickness of each layer may be between 2 and 300 nm, optionally between 20 and 300 nm. The minimum thickness of each layer is less than the maximum thickness of that respective layer. The minimum or maximum thickness of each layer may be at the first end of that layer. The other of the minimum or maximum thickness of the respective layer may be at the second end of that layer.

At least one percentage change in thickness may be positive. At least one percentage change in thickness may be negative.

Each percentage change in thickness may be in the range -150% to +150%.

The number of layers of the plurality of layers may be at least 10, optionally at least 15, optionally at least 20. The number of layers of the plurality of layers may be in the range 10 to 30, optionally, 15-25.

Summary of an improved waveguide coating

In overview, the present disclosure relates to a method of forming a transmission coating comprising a plurality of layers. There is disclosed herein a method for providing an unlimited number of gradient thicknesses with the same hardware. The present disclosure is based on a dual target and a shadow mask that provides a different coating contribution from each target such that small adjustments achievable without opening the coating chamber can caused significant changes to the coating gradient in order to provide enhanced design freedom.

The present disclosure is synergistic with the method of United States Patent US 11,852,832 and British patent application GB 2402387.1 which are each therefore incorporated herein by reference in their entirety. United States Patent US 11,852,832 discloses an improved efficiency method of fabricating graded coatings on a waveguide. The patent discloses that a percentage change in the thickness of each layer of the coating, from the first end to the second end, has one of a plurality of discrete allowed values, wherein the total number of layers is greater than the total number of discrete allowable values. British patent application GB 2402387.1 discloses a method of optimising coating by measuring a deviated coating function and modifying the coating design based on the deviated coating function in order that an improved coating may be provided without making hardware changes within the coating chamber such as changing the coating target.

The method of the present disclosure may comprise a step a of determining a first coating parameter and a coating function for each layer to optimise the transmissivity at a plurality of locations along the waveguide for a plurality of different wavelengths. The coating function is chosen from a plurality of allowable coating functions. Next, in these examples, there is a step b of forming the plurality of layers using the determined coating parameters and coating functions. Then, there is a step c of measuring a thickness of at least one layer at each of the plurality of locations. The measurements indicate that the coating function deviates from that selected during the optimisation of step a. Finally, there is a step d of determining a second coating parameter for at least one layer by repeating the optimisation of step a using the coating function derived from the measurements of step c. Notably, the coating function is not adjusted. That is, the coating function determined in step a is retained by step d. However, the present disclosure is not limited to these steps.

Summary of aspects and embodiments of the present disclosure

A first aspect of the present disclosure is a coating device comprising a sample carrier, a source (e.g. coating material source), shadow mask and coating driver. The source comprises a plurality of targets such as a first target and second target. The source is arranged to coat at least one sample housed in the sample carrier. The shadow mask is disposed in a line-of-sight between the sample carrier and source. The shadow mask is arranged (e.g. shaped and/or positioned) such that the first target provides a first coating contribution. The shadow mask is further arranged (e.g. shaped and/or positioned) such that the second target provides a second coating contribution. The second coating contribution is different (e.g. unequal in magnitude such as coating rate or rate of deposition) to the first coating contribution. At least one of the first and second coating contributions is non-uniform in a first dimension (on the surface) of the sample. The coating driver (e.g. power source or plurality of power sources) is arranged to independently control the first coating contribution and second coating contribution such that a thickness gradient of the coating in the first direction is variable. The coating device may further comprise a vacuum chamber arranged to be filled with gas that facilitates coating such as physical vapour deposition e.g. sputtering. The vacuum chamber may house the sample carrier, source and shadow mask. The vacuum chamber may house other components that are externally controllable by the coating driver - e.g. without opening the vacuum chamber.

Coating devices, such as the one described in embodiments, are typically used to apply uniform optical coatings to a sample. Much resource is devoted to increasing the uniformity of the coating formed by such devices. The present disclosure describes a deviation from the conventional use of such coating devices. There is disclosed herein a method of operating a coating device - designed to provide uniform coatings - in order to facilitate a plurality of different coating gradients (that is, non-uniform coatings having a changing thickness in one direction or thickness gradient in one direction of the sample) using the same hardware - in particular, the same source and the same shadow mask. The method is characterised by use of a plurality of targets and a shadow mask that creates a plurality of different coating contributions using the plurality of targets. More specifically, the shadow mask creates a different coating contribution from each target. At least one of the coating contributions is non-uniform. The inventors found that when a plurality of different coating contributions is generated, software-controlled measures can be used to change the total coating contribution (e.g. thickness gradient), wherein the total coating contribution is the sum of the different coating contributions. For the avoidance of doubt, this cannot be achieved when the coating contributions of the different targets are identical. According to the present disclosure, an unlimited number of coating gradients may be achieved (within a certain range). This unlocks design freedom as there would be unlimited gradients available to choose from even when the number of different shadow masks available is limited. New coating design will be easier. This would benefit R&D, while mass production capacity decreases if the target without shadow mask is not running at 100% power. It will improve yield in mass production. The shadow mask degrades during continuous coating and will need frequent maintenance e.g. in line with the machine maintenance schedule. Fine tuning the gradient (by tuning the target without shadow mask) can compensate this. Another technical advancement provided by the present disclosure is that the target is uniformly consumed.

The source may be arranged to coat a plurality of samples, such as at least six samples, housed in the sample carrier.

The shadow mask may comprise a first shadow mask component (e.g. first non-uniform aperture) aligned with the first target to provide the first coating contribution. The shadow mask may additionally or alternatively comprise a second shadow mask component (e.g. second non-uniform aperture) aligned with the second target to provide the second coating contribution. The second shadow mask component may be absent. In other words, in some embodiments the shadow mask comprises a first shadow mask component aligned with the first target to provide the first coating contribution and a second shadow mask component aligned with the second target to provide the second coating contribution (e.g. wherein the first shadow mask component is different to the second shadow mask component), and in alternative embodiments the shadow mask comprises the first shadow mask component aligned with the first target to provide the first coating contribution and the second shadow mask component is absent.

The first shadow mask component may define a first coating aperture that varies in size in the first dimension of the sample. Alternatively, or additionally, the second shadow mask component may define a second coating aperture that varies in size in the first dimension of the sample.

The first coating aperture may comprise alternating first and second sections. Each first section may comprise a (e.g. linear) increase in aperture size. Each second section may comprise a (e.g. linear) decrease in aperture size. For the avoidance of doubt, the present disclosure is not limited to linear gradients and first/second sections may comprise non-linear thickness gradients.

The increase in aperture size of the first section may be equal and opposite to the decrease in aperture size of the second section.

Each first and second section may correspond to a respective sample of the plurality of samples.

The coating driver may comprise at least one selected from the group comprising: a magnetic bar controller arranged to change the magnitude of a magnetic field at a plurality of positions of the source, a pressure controller arranged to change the pressure of a gas of the coating device; and a magnet swing arranged to control a direction of deposition.

The coating driver may be arranged to change the first coating contribution and/or second coating contribution by no more than 20% such as no more than 10% .

A material of the first target may be different to a material of the second target such that the coating is a blended target comprising material of the first target and the second target. A material of the first target may be the same as a material of the second target.

The first target and second target may be spatially separated.

A coating direction of the coating device may be substantially perpendicular to the first dimension of the sample.

Coating of the sample may comprise sputtering the target material.

The source may be arranged to rotate about an axis parallel to the first dimension.

A second aspect of the present disclosure is a method of changing the thickness gradient of a coating formed by source comprising a first target and second target. The method comprises the steps of: (shadow) masking, coating (or depositing) and software-controlling. The step of masking comprises arranging or disposing a shadow mask in a line-of-sight between the source and sample carrier such that the first target provides a first coating contribution and the second target provides a second coating contribution different to the first coating contribution. At least one of the first and second coating contributions is non-uniform in a first dimension of the sample or samples housed in the sampled carrier. The step of coating comprising directing (e.g. depositing or evaporating by e.g. physical vapour deposition) material from the first target and coating material from the second target towards the sample carrier (via the shadow mask). The method further comprises the step of software-controlling the first coating contribution and/or second coating contribution by changing an operating condition or parameter of a coating driver. According to this method, a thickness gradient of the coating in the first direction is variable such as continuously variable - at least, within an operating range.

Summary of terms

The term "hologram" is used to refer to the recording which contains amplitude information or phase information, or some combination thereof, regarding the object. The term "holographic reconstruction" is used to refer to the optical reconstruction of the object which is formed by illuminating the hologram. The system disclosed herein is described as a "holographic projector" because the holographic reconstruction is a real image and spatially-separated from the hologram. The term "replay field" is used to refer to the 2D area within which the holographic reconstruction is formed and fully focused. If the hologram is displayed on a spatial light modulator comprising pixels, the replay field will be repeated in the form of a plurality diffracted orders wherein each diffracted order is a replica of the zeroth-order replay field. The zeroth-order replay field generally corresponds to the preferred or primary replay field because it is the brightest replay field. Unless explicitly stated otherwise, the term "replay field" should be taken as referring to the zeroth-order replay field. The term "replay plane" is used to refer to the plane in space containing all the replay fields. The terms "image", "replay image" and "image region" refer to areas of the replay field illuminated by light of the holographic reconstruction. In some embodiments, the "image" may comprise discrete spots which may be referred to as "image spots" or, for convenience only, "image pixels".

The terms "encoding", "writing" or "addressing" are used to describe the process of providing the plurality of pixels of the SLM with a respective plurality of control values which respectively determine the modulation level of each pixel. It may be said that the pixels of the SLM are configured to "display" a light modulation distribution in response to receiving the plurality of control values. Thus, the SLM may be said to "display" a hologram and the hologram may be considered an array of light modulation values or levels.

It has been found that a holographic reconstruction of acceptable quality can be formed from a "hologram" containing only phase information related to the Fourier transform of the original object. Such a holographic recording may be referred to as a phase-only hologram. Embodiments relate to a phase-only hologram but the present disclosure is equally applicable to amplitude-only holography.

The present disclosure is also equally applicable to forming a holographic reconstruction using amplitude and phase information related to the Fourier transform of the original object. In some embodiments, this is achieved by complex modulation using a so-called fully complex hologram which contains both amplitude and phase information related to the original object. Such a hologram may be referred to as a fully-complex hologram because the value (grey level) assigned to each pixel of the hologram has an amplitude and phase component. The value (grey level) assigned to each pixel may be represented as a complex number having both amplitude and phase components. In some embodiments, a fully-complex computer-generated hologram is calculated.

Reference may be made to the phase value, phase component, phase information or, simply, phase of pixels of the computer-generated hologram or the spatial light modulator as shorthand for "phase-delay". That is, any phase value described is, in fact, a number (e.g. in the range 0 to $2\pi$) which represents the amount of phase retardation provided by that pixel. For example, a pixel of the spatial light modulator described as having a phase value of $\pi/2$ will retard the phase of received light by $\pi/2$ radians. In some embodiments, each pixel of the spatial light modulator is operable in one of a plurality of possible modulation values (e.g. phase delay values). The term "grey level" may be used to refer to the plurality of available modulation levels. For example, the term "grey level" may be used for convenience to refer to the plurality of available phase levels in a phase-only modulator even though different phase levels do not provide different shades of grey. The term "grey level" may also be used for convenience to refer to the plurality of available complex modulation levels in a complex modulator.

The hologram therefore comprises an array of grey levels - that is, an array of light modulation values such as an array of phase-delay values or complex modulation values. The hologram is also considered a diffractive pattern because it is a pattern that causes diffraction when displayed on a spatial light modulator and illuminated with light having a wavelength comparable to, generally less than, the pixel pitch of the spatial light modulator. Reference is made herein to combining the hologram with other diffractive patterns such as diffractive patterns functioning as a lens or grating. For example, a diffractive pattern functioning as a grating may be combined with a hologram to translate the replay field on the replay plane or a diffractive pattern functioning as a lens may be combined with a hologram to focus the holographic reconstruction on a replay plane in the near field.

Although different embodiments and groups of embodiments may be disclosed separately in the detailed description which follows, any feature of any embodiment or group of embodiments may be combined with any other feature or combination of features of any embodiment or group of embodiments. That is, all possible combinations and permutations of features disclosed in the present disclosure are envisaged.

BRIEF DESCRIPTION OF THE DRAWINGS

Specific embodiments are described by way of example only with reference to the following figures:

Figure 1 is a schematic showing a reflective SLM producing a holographic reconstruction on a screen;
Figure 2 shows a perspective view of a pair of wavefront replicators arranged for replication in two dimensions;
Figure 3 shows a cross-sectional schematic view of a first waveguide according to the present disclosure;
Figure 4 shows a close-up cross-sectional schematic view of a portion of the first waveguide of Figure 3;
Figure 5 shows a graph of the ideal increasing transmissivity of a waveguide in the direction of waveguiding;

Figure 6 show a cross-sectional schematic of a portion of an apparatus for manufacturing a waveguide according to the present disclosure in which a waveguide substrate is passing under a source of dielectric material;
Figure 7 is a schematic view of a shadow mask of the apparatus of Figure 6 comprising four apertures, the cross-section being in a plane that is orthogonal to the plane of the cross-section of Figure 6;
Figure 8A, Figure 8B, Figure 8C and Figure 8D show cross-sectional schematic views of four different waveguide substrates each having a layer of dielectric material formed on a first surface using the mask of Figure 7, wherein each layer has been formed using a different aperture of the mask;
Figure 9A, Figure 9B and Figure 9C show the cumulative effect of two targets coating at the same time when the respective masks are different; and
Figure 10 shows an example coating device in accordance with some embodiments.

The same reference numbers will be used throughout the drawings to refer to the same or like parts.

DETAILED DESCRIPTION OF EMBODIMENTS

The present invention is not restricted to the embodiments described in the following but extends to the full scope of the appended claims. That is, the present invention may be embodied in different forms and should not be construed as limited to the described embodiments, which are set out for the purpose of illustration.

Terms of a singular form may include plural forms unless specified otherwise.

A structure described as being formed at an upper portion/lower portion of another structure or on/under the other structure should be construed as including a case where the structures contact each other and, moreover, a case where a third structure is disposed there between.

In describing a time relationship - for example, when the temporal order of events is described as "after", "subsequent", "next", "before" or suchlike - the present disclosure should be taken to include continuous and non-continuous events unless otherwise specified. For example, the description should be taken to include a case which is not continuous unless wording such as "just", "immediate" or "direct" is used.

Although the terms "first", "second", etc. may be used herein to describe various elements, these elements are not to be limited by these terms. These terms are only used to distinguish one element from another. For example, a first element could be termed a second element, and, similarly, a second element could be termed a first element, without departing from the scope of the appended claims.

Features of different embodiments may be partially or overall coupled to or combined with each other, and may be variously inter-operated with each other. Some embodiments may be carried out independently from each other, or may be carried out together in co-dependent relationship.

Conventional optical configuration for holographic projection

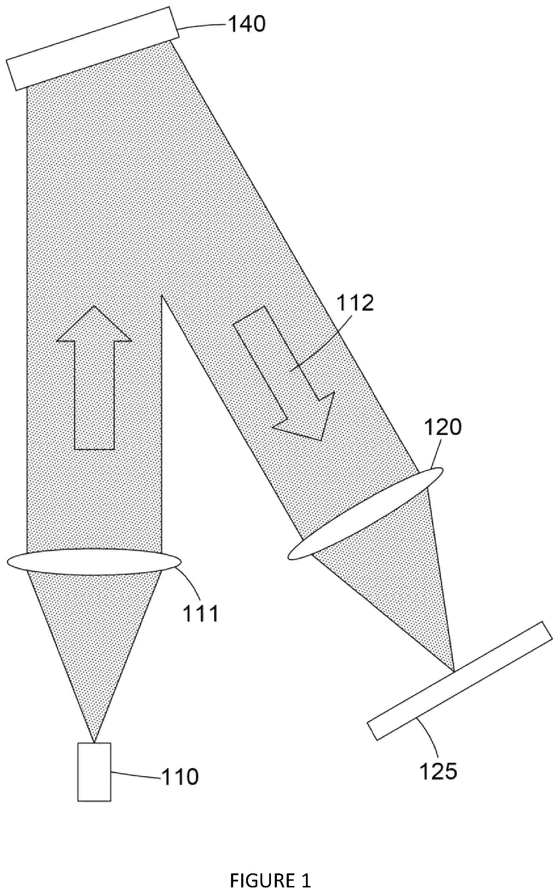

Figure 1 shows an embodiment in which a computer-generated hologram is encoded on a single spatial light modulator. The computer-generated hologram is a Fourier transform of the object for reconstruction. It may therefore be said that the hologram is a Fourier domain or frequency domain or spectral domain representation of the object. In this embodiment, the spatial light modulator is a reflective liquid crystal on silicon, "LCOS", device. The hologram is encoded on the spatial light modulator and a holographic reconstruction is formed at a replay field, for example, a light receiving surface such as a screen or diffuser.

A light source 110, for example a laser or laser diode, is disposed to illuminate the SLM 140 via a collimating lens 111. The collimating lens causes a generally planar wavefront of light to be incident on the SLM. In Figure 1, the direction of the wavefront is off-normal (e.g. two or three degrees away from being truly orthogonal to the plane of the transparent layer). However, in other embodiments, the generally planar wavefront is provided at normal incidence and a beam splitter arrangement is used to separate the input and output optical paths. In the embodiment shown in Figure 1, the arrangement is such that light from the light source is reflected off a mirrored rear surface of the SLM and interacts with a light-modulating layer to form an exit wavefront 112. The exit wavefront 112 is applied to optics including a Fourier transform lens 120, having its focus at a screen 125. More specifically, the Fourier transform lens 120 receives a beam of modulated light from the SLM 140 and performs a frequency-space transformation to produce a holographic reconstruction at the screen 125.

Notably, in this type of holography, each pixel of the hologram contributes to the whole reconstruction. There is not a one-to-one correlation between specific points (or image pixels) on the replay field and specific light-modulating elements (or hologram pixels). In other words, modulated light exiting the light-modulating layer is distributed across the replay field.

In these embodiments, the position of the holographic reconstruction in space is determined by the dioptric (focusing) power of the Fourier transform lens. In the embodiment shown in Figure 1, the Fourier transform lens is a physical lens. That is, the Fourier transform lens is an optical Fourier transform lens and the Fourier transform is performed optically. Any lens can act as a Fourier transform lens but the performance of the lens will limit the accuracy of the Fourier transform it performs. The skilled person understands how to use a lens to perform an optical Fourier transform.

In the example of Figure 1, an image is formed on a screen 125 by holographic reconstruction or transformation. The image may be replicated by a waveguide of the present disclosure. In this example, the waveguide receives, and replicates, a wavefront comprising spatially modulated light in accordance an image. In other examples of the present disclosure, an image is not formed on a screen and instead the hologram is propagated directly to the viewer. This may be described as hologram-to-eye and, at least conceptually, it may be said that the lens of the viewer's eye performs the hologram to image transformation. In these examples, it may be said that the waveguide receives, and replicates, a wavefront comprising spatially modulated light in accordance with a hologram of an image.

Hologram calculation

In some embodiments, the computer-generated hologram is a Fourier transform hologram, or simply a Fourier hologram or Fourier-based hologram, in which an image is reconstructed in the far field by utilising the Fourier transforming properties of a positive lens. The Fourier hologram is calculated by Fourier transforming the desired light field in the replay plane back to the lens plane. Computer-generated Fourier holograms may be calculated using Fourier transforms. Embodiments relate to Fourier holography and Gerchberg-Saxton type algorithms by way of example only. The present disclosure is equally applicable to Fresnel holography and Fresnel holograms which may be calculated by a similar method. In some embodiments, the hologram is a phase or phase-only hologram. However, the present disclosure is also applicable to holograms calculated by other techniques such as those based on point cloud methods.

In some embodiments, the hologram engine is arranged to exclude from the hologram calculation the contribution of light blocked by a limiting aperture of the display system. British patent application 2101666.2, filed 5 February 2021 and incorporated herein by reference, discloses a first hologram calculation method in which eye-tracking and ray tracing are used to identify a sub-area of the display device for calculation of a point cloud hologram which eliminates ghost images. The sub-area of the display device corresponds with the aperture, of the present disclosure, and is used exclude light paths from the hologram calculation. British patent application 2112213.0, filed 26 August 2021 and incorporated herein by reference, discloses a second method based on a modified Gerchberg-Saxton type algorithm which includes steps of light field cropping in accordance with pupils of the optical system during hologram calculation. The cropping of the light field corresponds with the determination of a limiting aperture of the present disclosure. British patent application 2118911.3, filed 23 December 2021 and also incorporated herein by reference, discloses a third method of calculating a hologram which includes a step of determining a region of a so-called extended modulator formed by a hologram replicator. The region of the extended modulator is also an aperture in accordance with this disclosure.

In some embodiments, there is provided a real-time engine arranged to receive image data and calculate holograms in real-time using the algorithm. In some embodiments, the image data is a video comprising a sequence of image frames. In other embodiments, the holograms are pre-calculated, stored in computer memory and recalled as needed for display on a SLM. That is, in some embodiments, there is provided a repository of predetermined holograms.

Two-Dimensional Pupil Expansion or Wavefront Replication

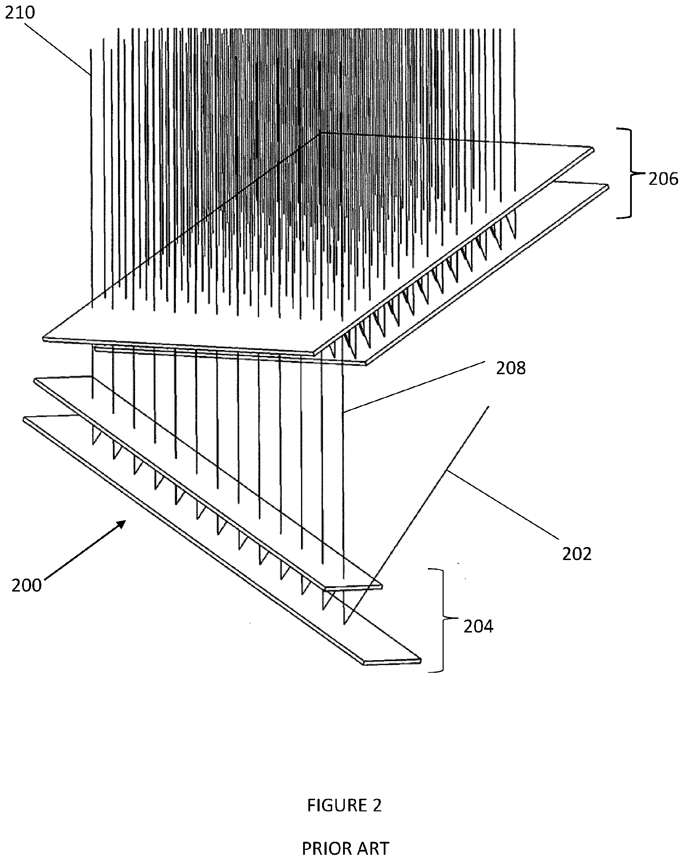

Figure 2 shows a perspective view of a system 200 comprising two pupil expanders or replicators, 204, 206 arranged for expanding a pupil or replicating a wavefront 202 in two dimensions.

In the system 200 of Figure 2, the first replicator 204 comprises a first pair of surfaces, stacked parallel to one another, and arranged to provide replication - or, pupil expansion The first pair of surfaces are similarly (in some cases, identically) sized and shaped to one another and are substantially elongate in one direction. The wavefront 202 is directed towards an input on the first replicator 204. The wavefront comprises spatially modulated light in an accordance with an image or a hologram of the image. Due to a process of internal reflection between the two surfaces, and partial transmission of light from each of a plurality of output points on one of the surfaces (the upper surface, as shown in Figure 2), which will be familiar to the skilled reader, light of the wavefront 202 is replicated in a first direction, along the length of the first replicator 204. Thus, a first plurality of replica wavefronts 208 is emitted from the first replicator 204, towards the second replicator 206.

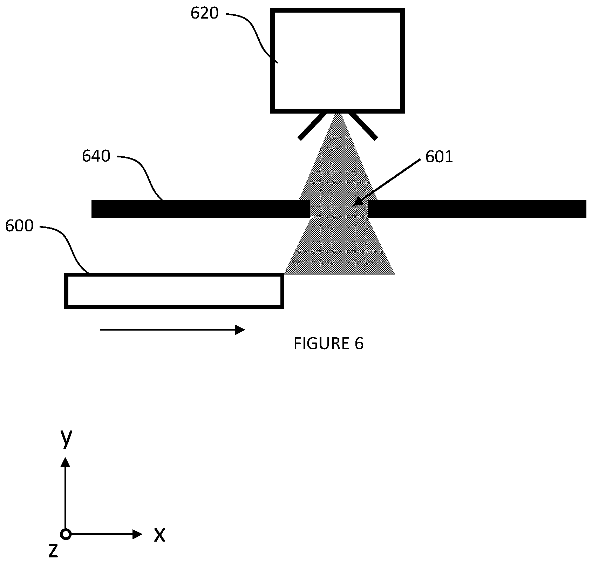

The second replicator 206 comprises a second pair of surfaces stacked parallel to one another, arranged to receive each of the collimated light beams of the first plurality of wavefronts 208 and further arranged to provide replication, or pupil expansion, by expanding each of those light beams in a second direction, substantially orthogonal to the first direction. The first pair of surfaces are similarly (in some cases, identically) sized and shaped to one another and are substantially rectangular. The rectangular shape is implemented for the second replicator in order for it to have length along the first direction, in order to receive the first plurality of wavefronts 208, and to have length along the second, orthogonal direction, in order to provide replication in that second direction. Due to a process of internal reflection between the two surfaces, and partial transmission of light from each of a plurality of output points on one of the surfaces (the upper surface, as shown in Figure 6), light of each light beam within the first plurality of wavefronts 208 is replicated in the second direction. Thus, a second plurality of wavefronts 210 is emitted from the second replicator 206, wherein the second plurality of wavefronts 210 comprises replicas of the wavefront 202 along each of the first direction and the second direction. Thus, the second plurality of wavefronts 210 may be regarded as comprising a two-dimensional grid, or array, of replica wavefronts. Thus, it can be said that the first and second replicators 204, 205 of Figure 2 combine to provide a two-dimensional replicator (or, "two-dimensional pupil expander").

Improved Waveguide

As described in relation to Figure 2, light in the waveguide is reflected between a partially reflective, partially transmissive surface and a reflective surface of a waveguide. Light may undergo one or more reflections or bounces between the two reflective / reflective-transmissive planar surfaces and, at each bounce point on the partially transmissive surface, the light is divided such that a portion of the light is emitted out of the waveguide and the remaining (typically larger) portion of the light is reflected to continue to propagate between the two surfaces of the waveguide. This effectively results in the partially transmissive surface of the waveguide providing a plurality, n, of light emission zones for light waveguided between the first surface and second surface. After each bounce point / emission zone, the intensity of the light propagating in the waveguide will decrease. In other words, the intensity of the light propagating in the waveguide decreases in the direction of waveguiding.

It is desirable for the intensity of the light emitted out of the waveguide at each of the n light emission zones to be substantially the same. This can be achieved this by providing an improved waveguide in which a layered coating is provided on the partially transmissive surface of the waveguide to cause the transmissivity of the partially transmissive surface to decrease in the direction of waveguiding. This accounts for the decrease in the intensity of the propagating light in the direction of waveguiding.

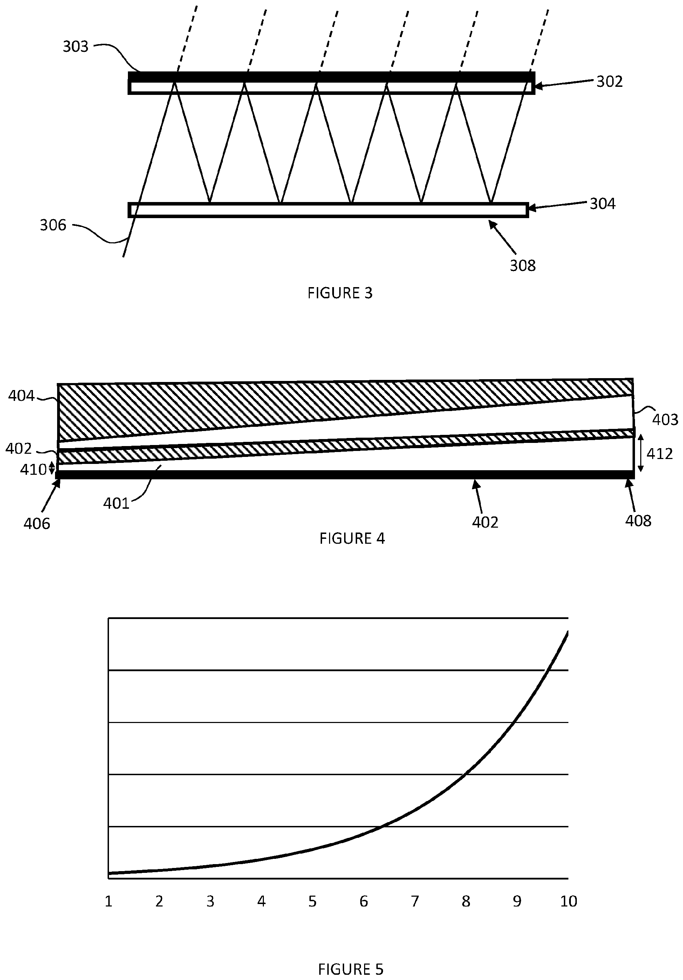

Figure 3 is schematic cross-sectional view of a waveguide 308 according to the disclosure. The waveguide 308 comprises a first surface 302 and a second surface 304. A light field or wavefront 306 (represented by one light ray in Figure 3) is shown propagating through the waveguide 308. The second surface 304 comprises an input port arranged to receive the light field. The first surface 302 is partially transmissive, partially reflective and comprises a coating 303. The term "coating" is merely used herein for convenience and the person skilled in the art will appreciate that components described as a "coating" may be formed by any method including, but not limited to, a coating process. The second surface 304 is substantially fully reflective (other than at the input). Figure 3 shows the path of the light field or wavefront through the waveguide, bouncing between the first and second surfaces. On each reflection at the first surface, the light field divides such that a portion of the light field is emitted through the first surface and a remaining portion is reflected and continues to propagate between the first and second surfaces by reflection. So, an emission zone is effectively formed at each reflection point. Figure 3 shows six emission zones, however the skilled person will understand that there could, of course, be a larger or smaller number of reflections and emission zones. Figure 3 is merely illustrative.

In some embodiments, the coating 303 comprises a plurality of layers of a first dielectric and a plurality of layers of a second dielectric in an alternating configuration. This is illustrated in Figure 4. The layers of the coating will be referred to herein by number, with the layer in contact with the first surface 302 being the first layer (layer 401). Layer 402 is on top of layer 401 and layer 403 is on top of layer 402. The layer furthest from the first surface 302, which is in top of layer 403, is the fourth layer 404. In this example, layers 401 and 403 are formed of silicon dioxide (SiO2) and layers 402 and 404 are formed of titanium dioxide (TiO2) such that the layers are in an alternating configuration in which subsequent layers of SiO2 (the first dielectric) are separated by layers of TiO2 (the second dielectric).

Each of layers 401 to 404 has a varying thickness in the direction of waveguiding (from left to right in Figure 4) and, in this embodiment by way of example, has a linear profile. In other words, the rate of change of thickness of each layer is constant. The profile of each layer can be characterized using a percentage change in thickness. Each layer has a first end 406 and a second end 408. The percentage change in thickness is defined as the change in thickness from the first end 906 to the second end 408 divided by the thickness at the first end 406 multiplied by 100. For the case of the first layer 401, the percentage change in thickness is 100 x (final thickness 412 - initial thickness 410) / initial thickness 410.

Layer 403 has the same percentage change in thickness as layer 401. Furthermore, the percentage change value is positive for both layers 401 and 403 (i.e. the thickness of the layer increases from the first end 406 to the second end 408). Layer 402 and 404 both have different percentage changes to one another and to layers 401 and 403. Furthermore, both the percentage change of layers 402 and 404 is negative (i.e. the thickness of the layers decreases from the first end 406 to the second end 408).

It has been found that by, selecting an appropriate number of alternating layers of the first and second dielectric, with the layers having an appropriate thickness and percentage change in thickness from the first end to the second end, a first surface of the waveguide can be provided having a transmissivity that increases in the direction of waveguiding. In this way, the intensity of the light field emitted at each emission zone (i.e. the intensity of each replica emitted at each emission zone) is substantially constant. This may advantageously achieve a substantially spatially homogeneous emission of light from the waveguide.

An ideal exponential increase of the transmissivity of the first surface 302 is shown in Figure 5 which is a graph showing transmissivity on the Y axis and position along the first surface 302 on the X axis. The numbers on the X axis represent the n emission zone. Specifically, the transmissivity increases according to the following equation: $T(n) = \frac{T(n-1)}{[1-T(n-1)]\times[1-L]}$  where L is the optical loss factor of the waveguide material.

Method of manufacture

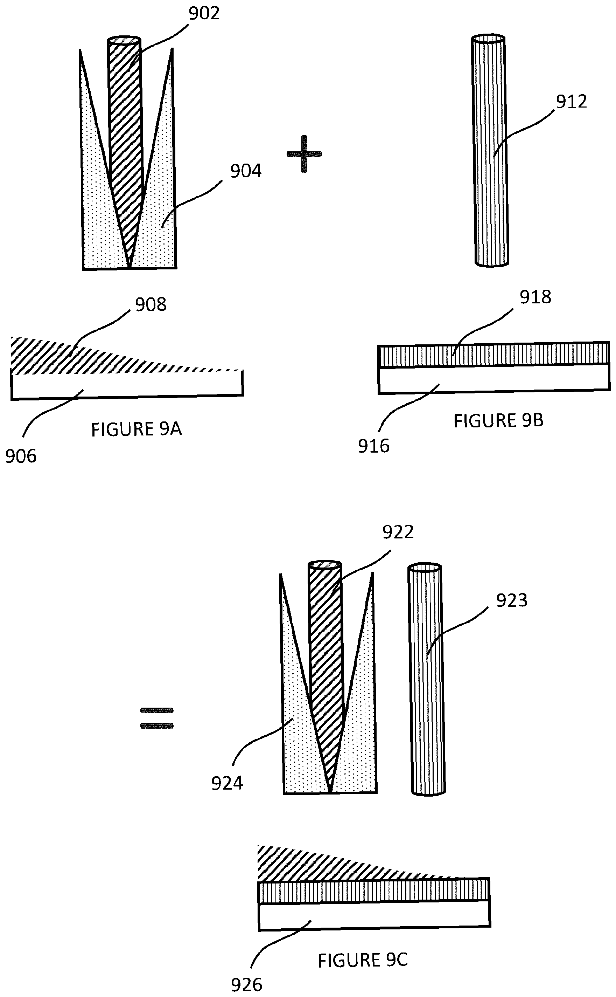

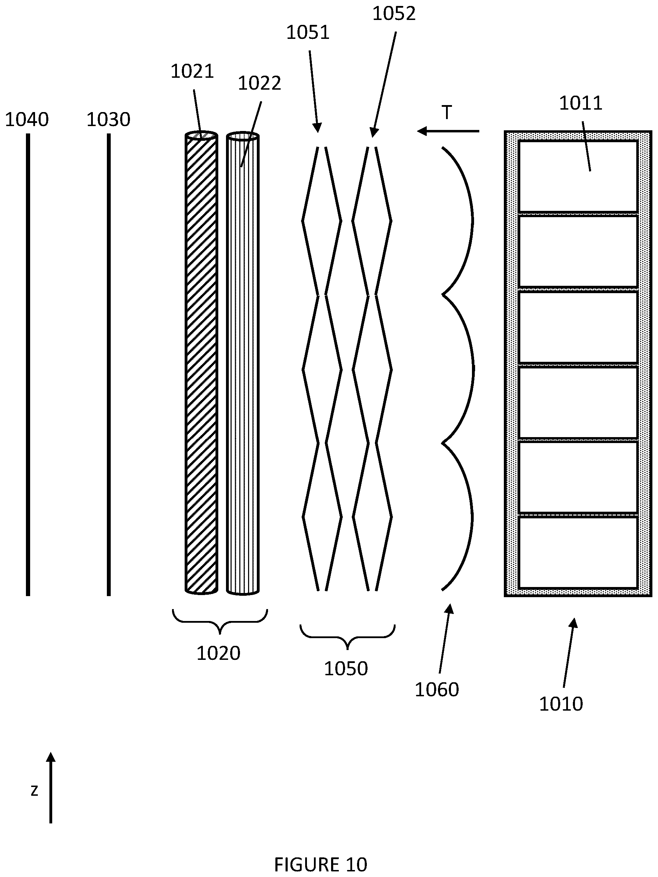

Figure 6, Figure 7, Figures 8A, Figure 8B, Figure 8C, Figure 8D, Figure 9A, Figure 9B, Figure 9C, and Figure 10 illustrate different examples of coating machines that may be used to implement the method and device disclosed herein. Figure 6, Figure 7, Figure 8A, Figure 8B, and Figure 8C show a first example which is a planar coating machine in which the sample/s move on the XZ plane. Figure 9A, Figure 9B, Figure 9C and Figure 10 show a second example of a so-called drum coating machine. The present disclosure is not limited to any particular coating geometry and two embodiments are described herein by way of example only.

An advantage of the layered coating of the present disclosure is that it can be manufactured in an inexpensive, fast and reliable way. Herein, one example of such a method is disclosed. However, the skilled person will appreciate that other methods are possible.

An apparatus for performing the method comprises two sources of a first dielectric material (for example SiO2) and two sources of a second dielectric material (for example TiO2), a shadow mask comprising first to fourth trapezoidal apertures and a means for moving a waveguide substrate with respect to the shadow mask. Each aperture of the shadow mask is associated with a source of dielectric material. During manufacture of each layer, dielectric material from the one of the sources is configured to flow through one of the apertures of the shadow mask. A waveguide substrate is moved with respect to the shadow mask (or vice versa) such that the shadow mask is between the source and the waveguide substrate. The waveguide substrate passes under the aperture and a layer of dielectric material is formed on a surface of the waveguide substrate.

Figure 6 is a schematic cross-sectional view of a portion of the apparatus for manufacturing a waveguide according to the present disclosure, the cross-section being in X-Y plane. The portion of the apparatus shown in Figure 6 comprises a first source of SiO2 and a shadow mask 640 comprising a first aperture 601. A waveguide substrate 600 (in the form of a glass or Perspex block or slab) is also shown. SiO2 material is configured to flow out of the first source 620 and through the first aperture 601 of the shadow mask 640. The flow of material is in the negative Y direction. The shape of the first aperture 601 determines the shape of the flow SiO2 downstream of the shadow mask 640. Figure 6 is not drawn to scale.

The means to move the waveguide substrate 600 (not shown in drawings) is arranged to move the waveguide substrate 600 in a first plane that is perpendicular to the Y direction such that the waveguide substrate 600 passes under the first aperture 601. In some embodiments, the motion is entirely in the X direction. However, in other embodiments the waveguide substrate 600 may be rotated in the first plane such that the motion is in both an X direction and a Z direction.

In Figure 6, the waveguide substrate 600 has yet to pass under the first aperture 601 and so no coating layer is present on the waveguide substrate 600. As the waveguide substrate passes under the first aperture 601 (in the X direction), dielectric coating is deposited on the substrate. Generally, in order to manufacture a complete layer, the waveguide substrate 600 will need to pass under the first aperture 601 multiple times until the desired thickness is achieved.

Once the first layer has been formed, the waveguide substrate 600 will be moved under one of the sources of second dielectric material such that a second layer of (of second dielectric material) is formed on top of the first layer of first dielectric material.

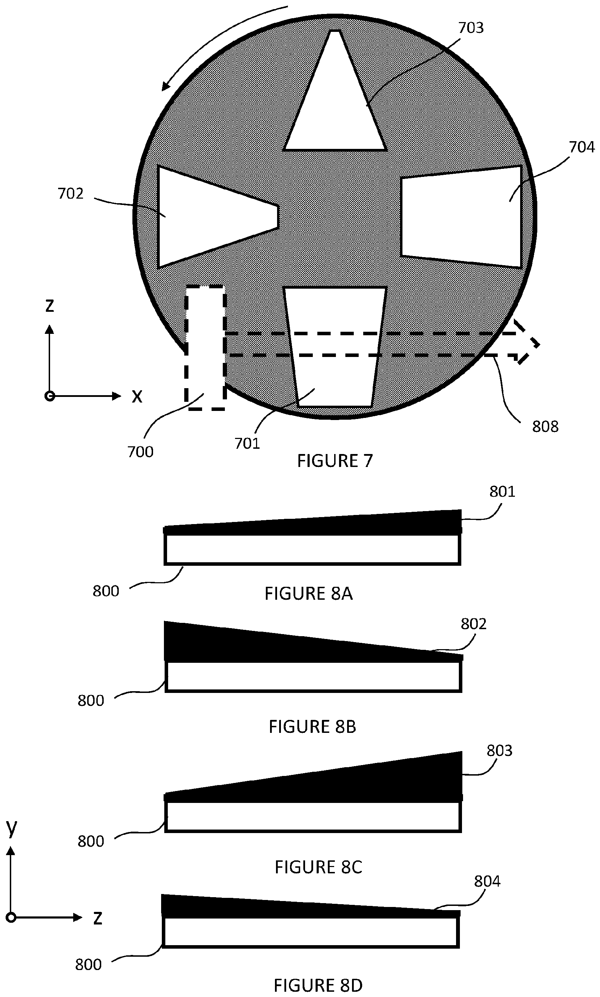

Figure 7 is a schematic view of the shadow mask, the view being taken in the X-Z plane (i.e. orthogonal to the plane of view of Figure 6). The shadow mask comprises four apertures, the first aperture 701 (described above), a second aperture 702, a third aperture 703 and a fourth aperture 704. By way of example only, the first and third apertures 701, 703 may be associated with a first source(s) of a first dielectric material. By way of example only, the second and fourth apertures 702, 704 may be coupled to a second source(s) of a second dielectric material. Each of the apertures has a trapezoidal shape comprising a short base and a long base forming a gradient thickness coating in the z-direction.

The waveguide substrate 700 is movable (e.g. translated such as shown by dashed arrow 750 and/or rotated) to be positioned under different apertures in turn. The order of the layers can be controlled depending on the order of the apertures that the waveguide substrate 700 is moved under. The waveguide substrate 700 is moved (e.g. translated in the x-direction and/or rotated) with respect to the shadow mask in order to pass under different apertures in turn such that the waveguide substrate 700 is passed under each aperture such that short base and long base of the aperture spaced apart in the Z direction. In this example, the shadow mask is rotatable such that the waveguide substrate 700 receives a gradient thickness (in the z-direction) coating through one aperture at a time. In Figure 7, the first aperture 701 is active - i.e. positioned to provide coating. In this way, the thickness of each deposited layer in the Z direction varies. A percentage change in the thickness of the layer from a first end to a second end (in the Z direction) will depend on the percentage change in width of the short base and the long base of the respective aperture. Whilst Figure 7 shows linear translation of the substrate and rotation of the shadow mask, the present disclosure is not limited to this arrangement and any method of bring different apertures into and out of engagement with the substrate one at a time is encompassed by the present disclosure. Different apertures may correspond to different coating materials.

Figure 8A, Figure 8B, Figure 8C, and Figure 8D are each cross-sectional schematic views of four different first layers formed on a waveguide substrate 800. Figure 8A shows a first layer 801 formed when the waveguide substrate 800 is passed under first aperture 701. Figure 8B shows a second layer 802 formed when the waveguide substrate 800 is passed under second aperture 702. Figure 8C shows a third layer 803 formed when the waveguide substrate 800 is passed under third aperture 703. Figure 8D shows a fourth layer 804 formed when the waveguide substrate 800 is passed under fourth aperture 804. As the skilled person will appreciate, the thickness profile of each of first to fourth layers 801 to 804 corresponds to the shape of the respective aperture.

In particular, first and third layers 801, 803 have a positive gradient from left to right because the width of the first and third apertures 701, 703 increase in the Z direction when the aperture and the waveguide substrate are aligned as per Figure 7. The percentage change in thickness of the third layer 803 is greater than that of first layer 801 because the percentage change of the width of the short base to the long base of third aperture 703 is greater than that of the first aperture 701. Second and fourth layers 802, 804 have a negative gradient from left to right because width of second and fourth apertures 702, 704 decrease in the Z direction when the shadow mask and the waveguide substrate are rotated into alignment as per Figure 7. The percentage change in thickness of the second layer 802 is greater than that of the fourth layer 804 because the percentage change of the width of the short base to the long base of second aperture 702 is greater than that of the fourth aperture 704.

As will be appreciated, the arrangement of the shadow mask with four differently shaped apertures and with two apertures connected to a first dielectric material source and two apertures connected to a second dielectric material source provides a means for manufacturing a plurality of layers of a first dielectric and a plurality of layers of second dielectric arranged in an alternating configuration. Each layer of the first dielectric will have a percentage change in thickness equal to either a first value or a second value, wherein all layers having the first value are related to, for example, the first aperture 701 and all layers having the second value are related to, for example, the second aperture 702. Each layer of the second dielectric will have a percentage change in thickness equal to either a third value or a fourth value, wherein all layers having the third value are related to, for example, the third aperture 703 and all layers having the fourth value are related to, for example, the fourth aperture 704.

The advantages of this method of manufacture are that the waveguide substrate can quickly and simply be moved / rotated to pass under the apertures of the shadow mask as necessary to build up a plurality of alternating layers of the first and second dielectric material, as necessary. The number of unique masks having a different shape governs the number of discrete values for the percentage change in thickness of layers that are available and so the percentage change in thickness of any particular layer can be controlled simply by selecting the aperture order. The absolute thickness of any layer can be controlled by either controlling the speed at which the waveguide substrate passes under a particular shadow mask 604 or be controlling the material flow speed.

It should be understood that the manufacturing method disclosed herein is not restricted to their being four apertures and two sources of dielectric material. For example, increasing or decreasing the number of differently shaped masks will simply have the effect of increasing or decreasing the discrete number of allowable percentage change in thickness values of layers available.

Improved Method of Coating Application and British patent application GB 2402387.1

The present disclosure is compatible with a method of coating design that includes the following steps:

1. designing the base structure, which is usually a multilayer mirror with RGB windows to be used at the lowest T% position. There is no gradient involved in this step; and
2. applying linear gradient on the multilayer base structure, optimising the gradient so that coating transmission at different positions can meet any requirements.

The general idea is to use the gaps among RGB (red-green-blue) windows as design freedom to help maintaining a stable and synchronised increase of transmission within RGB windows. As a result, the design is very sensitive to gradient - a small amount of change (several percentage) may change coating transmission drastically.

In practice, it can be difficult to adjust the mask to meet the same gradient thickness as designed. There are several challenges:

- adjusting the mask is a time-consuming process, which requires precise machining of metal;
- there is no simple relationship between gradient thickness and the physical gradient of the mask opening. To achieve linear gradient thickness, the mask usually needs to have some non-linearity. It is typically a trial-and-error process to get close to the required gradient after several iterations; and
- in mass production, masks will degrade in weeks and need maintenance/reconditioning. This increases the chances of small deviations in gradient thickness.

What usually happens is that the gradient masks are close to the design but not exactly accurate. To help work around these imperfect gradient masks, there is disclosed herein a 'post-process' coating optimisation, which does not need any hardware change but can deliver significant improvement to the coating performance. The method comprises:

- fixing the gradient ("coating function") as is - that is, accepting the small deviation, with no further optimisation; and
- finding the best sets of multilayer thicknesses that can 'fully utilise' the fixed gradient ("coating function").

Dual targets

There is disclosed herein a coating device in which the source comprises two targets. The source is the source of the material that forms the coating. The source therefore comprises two components referred to as two targets. Each target provides coating material. The composition of the first target may be the same or different to that of the second target. Figures 9A, 9B, 9C and Figure 10 relate to a drum coating machine by way of example only. Any coating configuration or geometry that can accommodate two targets and two respective masks - including a planar coating geometry - is compatible with the present disclosure.

Figure 9A shows a first target 902 and a first mask 904 arranged to form a first coating 908 on a substrate 906. The coating is a gradient thickness coating (i.e. has a thickness that changes) because of the first mask. In top drawing of Figure 9A, the coating direction is out of the page. The bottom drawing of Figure 9A shows an orthogonal plane. The lefthand side of the first coating 908 has a greater thickness than the righthand side in accordance with the shape of the mask. The mask is an aperture as per Figure 7, Figure 8A, Figure 8B, Figure 8C, and Figure 8D and the first coating 908 has a negative gradient in thickness.

Figure 9B shows a second target 912 arranged to form a second coating 918 on a substrate 916. The second coating 918 is uniform in thickness because of the absence of a mask.

In a dual target arrangement, the first target 902 and second target 912 may coat the substrate at the same time. For example, the first target 902 and second target 912 may be immediately adjacent in the coating chamber. This is shown in Figure 9C. The inventor has recognised that using this approach and different masks for the two targets, an unlimited number of different gradients can be accessed albeit within a certain range. It will be understood that coating the substrate "at the same time" means that the first and second coating contributions from the first and second targets are output from the targets at the same time (i.e. simultaneously, or at the same first time), although it may not necessarily always be the case that the first and second contributions are both incident on the substrate at the exact same time due to the rotational nature of the coating arrangement (but the coating contributions may indeed be incident on the substrate simultaneously for at least a portion of a rotation of the substrate or shadow mask).

In an example, assume the first target 902 with the first mask 904 forms a first coating 908 having gradient thickness from 1.0 to 0.5. When the second target 912 without a mask is running at 100% power, it has uniform thickness 1.0. Then the combined gradient would become from 1.5 (0.5+1) to 2 (1+1), equivalent to from 0.75 to 1. When the second target 912 without the mask is running at 0% power, it has uniform thickness 0. The gradient remains 0.5 to 1.

Therefore, by controlling a power of the second target 912 without a mask, the thickness gradient of each coating layer (coated by this target pair) can vary freely between '0.5 to 1' to '0.75 to 1'. This is the principle of the present disclosure that therefore provides an unlimited number of gradients. Notably, this is achieved using the same hardware - that is, without changing any targets or masks - which is described as a "hardware change" as opposed to a "software change" which might be achieved by changing a power of the coating process as described above. This is achievable because a gradient of the two masks is different - or only one mask is used. The gradient of a mask may be the rate of change of the size of an aperture of the mask in a dimension of the substrate - which may correspond to the general direction of waveguiding when in-use.

The effect of the unlimited gradient within certain range is that it unlocks lots of design freedom as there would be unlimited gradients available to choose from, even though the number of shadow masks is limited. New coating design will be easier. This would benefit the design process most, while mass production capacity decreases if the target without shadow mask is not running at 100% power. It will improve yield in mass production. The shadow mask degrades in continuous coating and will need frequent maintenance. Fine tuning the gradient (by tuning the target without shadow mask) can compensate this.

Figure 10 represents a coating chamber for the coating device of the present disclosure. Figure 10 shows a sample carrier 1010 comprises a plurality of individual samples such as first sample 1011. Figure 10 shows a dual rotary source 1020 comprising a first target 1021 and second target 1022. Figure 10 further shows a gas control 1030 which provides ten adjustment positions along the full length and a remotely adjustable magnetic, "RAM", bar 1040 which also provides ten adjustment positions along its full length. A shadow mask 1050 comprises a first mask 1051 aligned with the first target 1021 and a second mask 1052 aligned with the second target 1022. In this drawing, the first mask 1051 and second mask 1052 are the same but, in embodiments, the first mask 1051 and second mask 1052 are different. More specifically, a gradient of the first mask 1051 is different to that of the second mask 1052. Yet more specifically, a rate of change of the aperture size of the first mask 1051 (in the required gradient or z-direction) is different to that of the second mask 1052. Figure 10 shows how each mask comprises a plurality of sections forming alternate positive and negative gradients. Each section corresponds to a respective sample. The gradient thickness 1060 of the coating formed on the samples by the first and second targets is shown in Figure 10.

In accordance with the present disclosure, a dual target with different gradient masks is used in order that small changes made to the coating environment or parameters cause useful changes to the coating gradient. There is disclosed herein a method of using a coating device designed for providing high uniformity coatings to alternative provide an unlimited number of different gradient thickness coatings on a plurality of relatively small samples at the same time. These small changes are software driven and achievable without opening the chamber or changing a shadow mask of the process. Three software driven methods of changing the gradient thickness are given in the following three paragraphs by way of example only.

In a first example, a RAM bar 1040 directly changes a magnetic field of the coating process. For example, the coating process may comprise sputtering such as magnetron sputtering. There is a plurality of adjustable positions or drive or operation levels - such as ten adjustment positions - in the full length which is not enough to provide an adequate gradient in e.g. six samples. The feature is typically provided to facilitate the formation of uniform rather than gradient thickness coatings. In other words, this feature is provided for uniformity adjustment. But, in accordance with embodiments, this feature is alternatively used to provide a relatively small adjustment of a coating parameter in order to access different gradients from a dual target source without changing the shadow mask.

In a second example, the gas pressure inside the chamber is adjusted. In some embodiments, the gas is argon and Ar+ ions bombard the target/s to cause eject of coating material towards the sample carrier. The gas control 1030 has a plurality of adjustable positions or drive or operation levels - such as five or ten adjustable positions - which is also not enough to provide an adequate gradient in e.g. six slabs but is good for the formation of uniform coatings and uniformity adjustment. The feature is typically provided to facilitate the formation of uniform rather than gradient thickness coatings. In other words, this feature is provided for uniformity adjustment.

But, in accordance with embodiments, this feature is alternatively used to provide a relatively small adjustment of a coating parameter in order to access different gradients from a dual target source without changing the shadow mask.

In a third example, a slight adjustment of a so-called magnet swing changes the direction of deposition.

These three examples are control parameters in addition to the gradient shadow mask that physically blocking deposition to achieve gradient. The dual rotary target may have two sets of masks (one for each). The gradient shadow mask possibly causes lower target utilisation (design dependent) but, in practice, the material cost is almost negligible in coating. The relatively small adjustments of the three examples referred to above are relatively small compared to the impact of the mask. The relatively small adjustments referred to above are achieved by software control rather than hardware control such as changing a mask inside the chamber. The gradient shadow mask is the primary source of the gradient and the software-controlled methods are good to improve yield by small adjustments.

In some embodiments, the dual rotary target is configured to have two different materials. The two sets of gradient masks for this dual rotary target can also be different. This effectively creates gradient index mix-material in sputtering, with gradient direction parallel to the dual rotary target. Mix-material sputtering is more stable in a single set of dual rotary target than using two physically separated targets. In some embodiments, inline ellipsometry without vacuum break is used to tune the gradient index in spec within a short time. In some embodiments, optical monitoring is also used.

Additional features

The methods and processes described herein may be embodied on a computer-readable medium. The term "computer-readable medium" includes a medium arranged to store data temporarily or permanently such as random-access memory (RAM), read-only memory (ROM), buffer memory, flash memory, and cache memory. The term "computer-readable medium" shall also be taken to include any medium, or combination of multiple media, that is capable of storing instructions for execution by a machine such that the instructions, when executed by one or more processors, cause the machine to perform any one or more of the methodologies described herein, in whole or in part.

The term "computer-readable medium" also encompasses cloud-based storage systems. The term "computer-readable medium" includes, but is not limited to, one or more tangible and non-transitory data repositories (e.g., data volumes) in the example form of a solid-state memory chip, an optical disc, a magnetic disc, or any suitable combination thereof. In some example embodiments, the instructions for execution may be communicated by a carrier medium. Examples of such a carrier medium include a transient medium (e.g., a propagating signal that communicates instructions).

It will be apparent to those skilled in the art that various modifications and variations can be made without departing from the scope of the appended claims. The present disclosure covers all modifications and variations within the scope of the appended claims and their equivalents.

**Claims**

1. A coating device comprising:

    a sample carrier;
    a source comprising a first target and a second target, wherein the source is arranged to coat a sample housed in the sample carrier;
    a shadow mask disposed between the sample carrier and source, wherein the shadow mask is arranged such that the first target provides a first coating contribution and the second target provides a second coating contribution different to the first coating contribution, wherein at least one of the first and second coating contributions is non-uniform in a first dimension of the sample; and
    a coating driver arranged to independently control the first coating contribution and second coating contribution such that a thickness gradient of the coating in the first direction is variable.

2. A coating device as claimed in claim 1 wherein the source is arranged to coat a plurality of samples, such as at least four or six samples, housed in the sample carrier.

3. A coating device as claimed in any preceding claim wherein the shadow mask comprises a first shadow mask component aligned with the first target to provide the first coating contribution and/or a second shadow mask component aligned with the second target to provide the second coating contribution.

4. A coating device as claimed in claim 3 wherein the first shadow mask component defines a first coating aperture that varies in size in the first dimension of the sample and/or the second shadow mask component defines a second coating aperture that varies in size in the first dimension of the sample.

5. A coating device as claimed in claim 4 wherein the first coating aperture comprises alternating first and second sections, wherein each first section comprises a increase in aperture size and each second section comprises a decrease in aperture size.

**6.** A coating device as claimed in claim 5 wherein the increase in aperture size of the first section is equal and opposite to the decrease in aperture size of the second section.

**7.** A coating device as claimed in claim 5 or 6, when dependent on claim 2, wherein each first and second section corresponds to a respective sample of the plurality of samples.

**8.** A coating device as claimed in any preceding claim wherein the coating driver comprises at least one selected from the group comprising: a magnetic bar controller arranged to change the magnitude of a magnetic field at a plurality of positions of the source, a pressure controller arranged to change the pressure of a gas of the coating device; and a magnet rotator arranged to control a direction of deposition (in a plane perpendicular to the vertical direction.

**9.** A coating device as claimed in any preceding claim wherein the coating driver is arranged to change the first coating contribution and/or second coating contribution by no more than 20% such as no more than 10%.

**10.** A coating device as claimed in any preceding claim wherein a material of the first target is different to a material of the second target such that the coating is a blended target comprising material of the first target and the second target.

**11.** A coating device as claimed in any preceding claim wherein a material of the first target is the same as a material of the second target.

**12.** A coating device as claimed in any preceding claim wherein the first target and second target are spatially separated.

**13.** A coating device as claimed in any preceding claim wherein a coating direction of the coating device is substantially perpendicular to the first dimension of the sample.

**14.** A coating device as claimed in any preceding claim wherein coating of the sample comprises sputtering the target material.

**15.** A coating device as claimed in any preceding claim wherein the source is arranged to rotate about an axis parallel to the first dimension.

**16.** A method of changing the thickness gradient of a coating formed by source comprising a first target and second target, the method comprises:

shadow masking by arranging or disposing a shadow mask in a line-of-sight between the source and sample carrier such that the first target provides a first coating contribution and the second target provides a second coating contribution different to the first coating contribution, wherein at least one of the first and second coating contributions is non-uniform in a first dimension of the sample or samples housed in the sampled carrier;

depositing material from the first target and coating material from the second target towards the sample carrier via the shadow mask; and

software-controlling the first coating contribution and/or second coating contribution by changing an operating condition or parameter of a coating driver of the coating device such that a thickness gradient of the coating in the first direction is continuously variable.

FIGURE 1

FIGURE 2

PRIOR ART

303

302

306

304

308

FIGURE 3

404

402

410

406

401

403

412

402

408

FIGURE 4

FIGURE 5

620

640

601

600

FIGURE 6

y

x

z

FIGURE 7

FIGURE 8A

FIGURE 8B

FIGURE 8C

FIGURE 8D

902

904

+

912

908

906

FIGURE 9A

918

916

FIGURE 9B

922

923

=

924

926

FIGURE 9C

FIGURE 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11852832 B
- GB 2402387 A
- GB 2101666 A
- GB 2112213 A
- GB 2118911 A